# EUROPEAN PATENT APPLICATION

(11) **EP 1 788 398 A1**
(43) Date of publication of application: **23.05.2007**
(21) Application number: 05767130.7
(22) Date of filing: 28.07.2005
(51) Int. Cl.: G01R 19/00

(54) **DETECTOR**

(30) Priority: 30.07.2004 JP 2004223033
(71) Applicant: Tamura Corporation, Tokyo 178-8511 (JP)
(72) Inventor: KOBAYASHI, Masakazu c/o TAMURA CORPORATION, Saitama, 350-0214 (JP)
(74) Representative: Schwabe - Sandmair - Marx
(86) International application number: PCT/JP2005/013851
(87) International publication number: WO 2006/011560

(57) **Abstract**

A detector wherein a measuring range can be easily switched without increasing mounting area and manufacturing cost. The detector is provided with an EEPROM (4) wherein a plurality of digital value groups are stored by having digital values indicating gain and offset respectively as one group; an instruction means which adds to the EEPROM (4) an instruction to read one group of digital values from the plurality of groups; DA converters (5A, 5B) for converting the digital values of the gain and the offset read from the instructing means into analog values; and a current sensor (6), which adjusts the gain and the offset by output from the DA converters (5A, 5B) and then outputs the detected results.

## Description

### Technical Field

The present invention relates to a detector detecting current or the like.

### Background Art

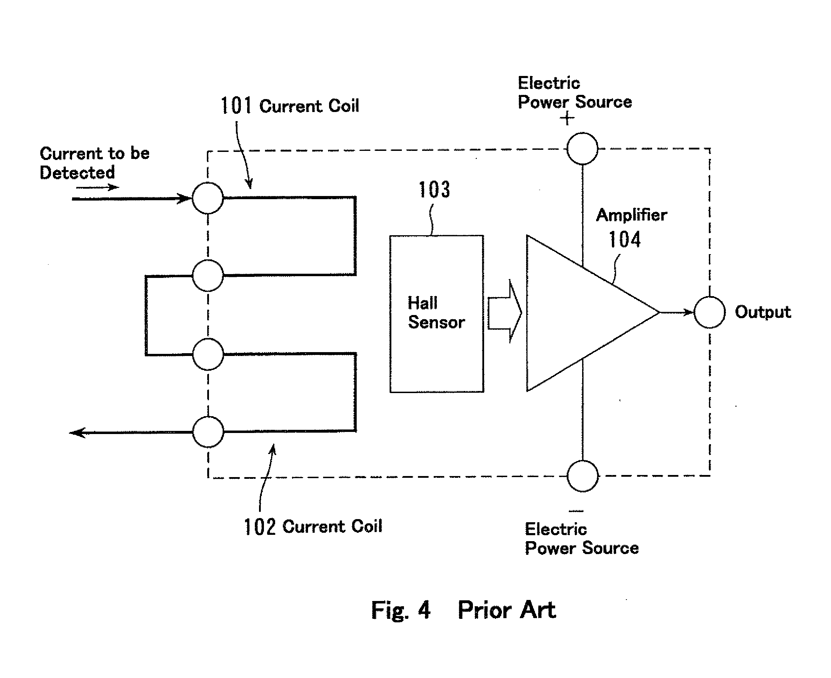

There are various types of detectors; for example, some current detectors have a plurality of measurement ranges. This current detector is illustrated in Figure 4. The current detector of Figure 4 is one capable of performing selection between 10 [A] and 20 [A], and includes current coils 101 and 102, a hall sensor 103 and an amplifier 104. When the measurement range of the current detector is changed to 10 [A], the current coils 101 and 102 are connected in series and a current to be measured is carried from the current coil 101 to the current coil 102. At this time, magnetic field generated by the current coils 101 and 102 is detected by the hall sensor 103 and further a detection signal outputted by the hall sensor 103 is amplified by the amplifier 104. In this case, the amplifier 104 is driven by positive (+) and negative (-) power sources.

In this manner, current detection in the measurement range of 10 [A] is performed by the current detector of Figure 4.

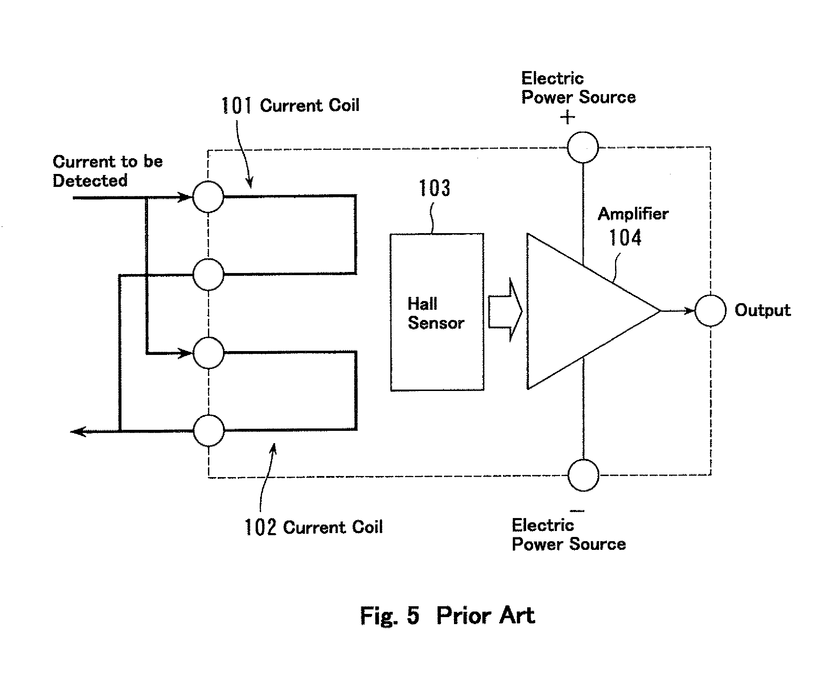

When the measurement range of the current detector of Figure 4 is changed to 20 [A], the current coils 101 and 102 is, as illustrated in Figure 5, connected in parallel and a current to be measured is carried simultaneously into the current coils 101 and 102. With the above arrangement, a larger current to be measured can be made to flow, compared to when the current coils 101 and 102 are connected in series, thus allowing selection between the measurement ranges.

Meanwhile, the conventional current detector described above has the following problem. That is, in the conventional current detector, selection between measurement ranges is performed by changing the connection state of the current coils 101 and 102. Accordingly, when the current detector has a plurality of measurement ranges, two or more current coils are needed, thus leading to an increase in mounting area and a rise in manufacturing cost. Further, when the measurement range is changed after mounting the current detector, the board pattern having mounted thereon the current coils 101 and 102 must be varied to change the connection state of the current coils 101 and 102. Therefore, it is difficult to perform selection between the measurement ranges.

To solve the above problem, an object of the present invention is to provide a detector allowing selection between measurement ranges to be easily performed without involving an increase in mounting area and a rise in manufacturing cost.

### Disclosure of the Invention

To solve the above problem, according to the present invention of claim 1, there is provided a detector characterized by including: storage means having stored therein a plurality of groups of digital values, the digital values indicating a gain and an offset, respectively, and being set as one group; instruction means for supplying to the storage means an instruction for reading one set of digital values from among the plurality of groups; D/A converters respectively converting the digital values of gain and offset read by use of the instruction means into analog values; and detection means for performing gain and offset adjustment based on outputs from the D/A converters and thereafter outputting a detection result.
According to the present invention of claim 2, there is provided the detector according to claim 1 characterized in that the storage means is a nonvolatile memory capable of electrically rewiring the digital values.
According to the present invention of claim 3, there is provided the detector according to claim 2 characterized by further including rewrite means for rewriting the gain and offset values stored by the nonvolatile memory.

According to the present invention of claim 1, a gain and offset required by the detection means in performing selection between measurement ranges are selected and extracted from the storage means, and the detection means is adjusted based on the read gain and offset, and thereafter a detection result is outputted by the detection means. Accordingly, in performing selection between measurement ranges, any connection change or the like of the detection means as with conventional art can be made unnecessary. As a result, an increase in mounting area for arranging the detection means and a rise in manufacturing cost can be prevented.
According to the present invention of claims 2 and 3, the digital values can be rewritten. Accordingly, varying of gain and offset after mounting, i.e., changing of measurement ranges can be easily performed.

### Brief Description of the Drawings

Figure 1 is a block diagram illustrating a current detector according to Embodiment 1;
Figure 2 is a block diagram illustrating a detection circuit of Figure 1;
Figure 3 is a block diagram illustrating a current detector according to Embodiment 2;
Figure 4 is a block diagram illustrating a conventional current detector; and
Figure 5 is a block diagram illustrating a manner in which the measurement range of the current detector of Figure 4 is changed.

### Description of Symbols

- 1: CPU
- 1A: Data bus
- 2: ROM
- 3: Switch circuit
- 4: EEPROM
- 4A to 4C: Data group
- 4D: Selection table
- 5A, 5B: DA converter
- 6: Current sensor
- 6A: Gain adjustment circuit
- 6B: Offset adjustment circuit
- 6C: Detection circuit
- 6D: Amplifier circuit
- 61: Current coil
- 62: Hail sensor
- 11: AD converter

### Best Mode for Carrying Out the Invention

Embodiments of the present invention will now be described in detail with reference to the drawings. In the following embodiments, a case where the present invention is applied to a current detector is taken as an example.

### [Embodiment 1]

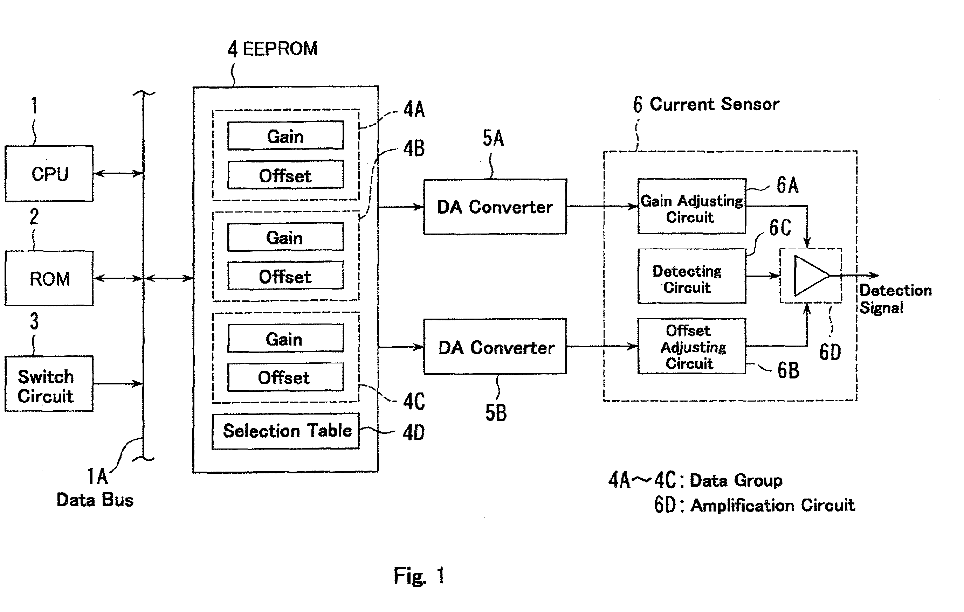

A current detector according to the present embodiment is illustrated in Figure 1. This current detector includes a CPU (Central Processing Unit) 1, a ROM (Read Only Memory) 2, a switch circuit 3, a nonvolatile memory serving as storage means, e.g., EEPROM (Electrically Erasable Programmable Read Only Memory) 4, DA (Digital-Analog) converters 5A and 5B, and a current sensor 6. The ROM 2, the switch circuit 3 and EEPROM 4 are connected via a data bus 1A to the CPU 1.

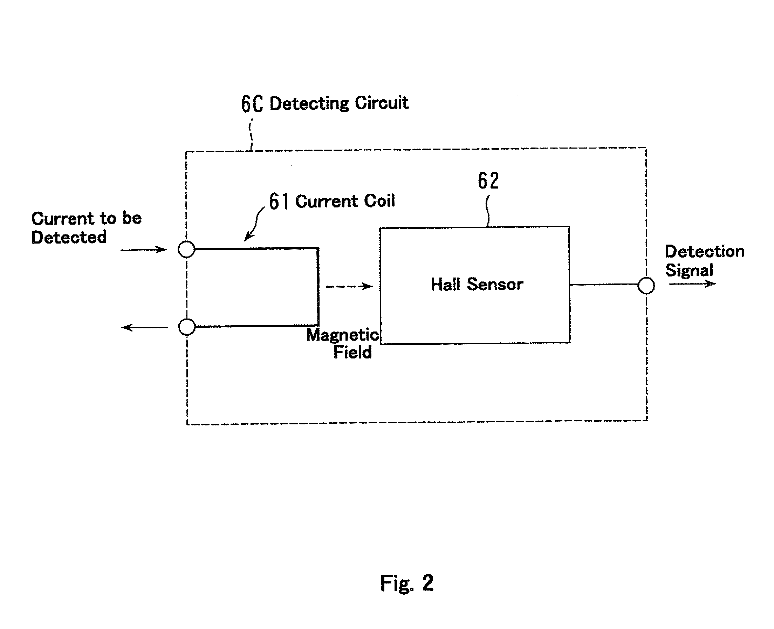

The current sensor 6 serves to detect a current and includes a gain adjustment circuit 6A, an offset adjustment circuit 6B, a detection circuit 6C and an amplifier circuit 6D. The detection circuit 6C includes, as illustrated in Figure 2, a current coil 61 having flowing therethrough a current to be measured, and a hall sensor 62. The hall sensor 62 detects a magnetic field generated by the current coil 61 when a current to be measured flows, and outputs a detection signal to the amplifier circuit 6D. The amplifier circuit 6D amplifies the detection signal supplied from the hall sensor 62 and outputs the signal. That is, the amplifier circuit 6D outputs the detection signal indicating the result of current detection.

When a measurement range is selected by the switch circuit 3, the current sensor 6 varies its sensitivity in accordance with this measurement range, thereby ensuring current measurement accuracy. Accordingly, the gain adjustment circuit 6A adjusts the gain of the amplifier circuit 6D; the offset adjustment circuit 6B adjusts the offset of the amplifier circuit 6D. The gain adjustment of the current sensor 6 determines the amplification degree of the amplifier circuit 6D; the offset adjustment determines the zero point of the amplifier circuit 6D. In adjusting the amplifier circuit 6D, the gain adjustment circuit 6A operates based on a gain adjustment signal supplied from the D/A converter 5A and the offset adjustment circuit 6B based on an offset adjustment signal supplied from the D/A converter 5B.

The EEPROM stores setting data required when the sensitivity of the current sensor 6 is varied. More specifically, with digital values respectively indicating a gain and offset of the current sensor 6 being set as one group, a plurality of the groups of digital values are stored therein. According to the present embodiment, the EEPROM 4 stores a data group 4A as setting data for 10 [A] of the current sensor 6, and a data group 4B as setting data for 20 [A] of the current sensor 6. Also, the EEPROM 4 stores a data group 4C as setting data for 30 [A] of the current sensor 6. In performing selection between measurement ranges 10 [A], 20 [A] and 30 [A], a plurality of the data groups 4A to 4C is needed for adjusting the current sensor 6. The gain and offset values of the current sensor 6 are varied in accordance with a sensitivity corresponding to the respective measurement ranges; further, the values also vary depending on current sensors. Accordingly, the gain and offset values of each data group 4A to 4C are preliminarily adjusted during the manufacturing process.

Also, the EEPROM 4 includes a selection table 4D. The selection table 4D is data indicating a correspondence relationship between the selection signal sent from the CPU 1 and the data groups 4A to 4C. When receiving a selection signal from the CPU 1, the EEPROM 4 consults the selection table 4D, reads gain and offset values of one group corresponding to the selection signal from among the data groups 4A to 4C, and outputs these values to the respective DA converters 5A and 5B as the gain adjustment signal and offset adjustment signal.

The EEPROM 4 for storing these data is electrically rewritable, so modification of the offset and gain of the data groups 4A to 4C or addition of a new data group is possible. When the EEPROM 4 is made to have a one-time function to permit only one writing or a write protect function to prohibit writing, it is possible to prevent data from being inadvertently rewritten. Modification or addition of gain and offset can be performed, for example by connecting an input device (not illustrated) to an interface (not illustrated) and sending data for the modification or addition from this input device to the CPU 1. In this case, the input device and CPU 1 are rewrite means for rewriting the EEPROM 4.

The DA converter 5A converts a digital gain adjustment signal sent from the EEPROM 4 into an analog gain adjustment signal; the DA converter 5B converts a digital offset adjustment signal sent from the EEPROM 4 into an analog offset adjustment signal.

The switch circuit 3 is one for performing selection between measurement ranges of the current sensor 6. When the operator manipulates the switch circuit 3 to select one measurement range from among 10 [A], 20 [B] and 30 [C], a digital selection signal corresponding to the selected measurement range is sent to the CPU 1.

The CPU 1 performs various types of control of the current detector according to procedures stored in the ROM 2. In addition to such control, when receiving the selection signal sent via the data bus 1A from the switch circuit 3, the CPU 1 outputs this selection signal to the EEPROM 4 similarly via the data bus 1A.

The current detector according to the present embodiment has the above described configuration. In using this current detector, the operator manipulates the switch circuit 3 to select a measurement range. The switch circuit 3 outputs a selection signal indicating the selected measurement range to the CPU 1. When receiving the selection signal, the CPU 1 sends this signal to the EEPROM 4. When receiving the selection signal, the EEPROM 4 consults the selection table 4D, reads gain and offset values of one group corresponding to the selection signal from among the data groups 4A to 4C, and outputs these values as the gain adjustment signal and offset adjustment signal to the respective DA converters 5A and 5B. The DA converter 5A converts the digital gain adjustment signal into an analog signal and outputs this signal to the gain adjustment circuit 6A of the current sensor 6; the DA converter 5B converts the digital offset adjustment signal into an analog signal and outputs this signal to the offset adjustment circuit 6B. The gain adjustment circuit 6A of the current sensor 6 adjusts the gain of the amplifier circuit 6D based on the gain adjustment signal sent from the DA converter 5A; the offset adjustment circuit 6B adjusts the offset of the amplifier circuit 6D based on the offset adjustment signal sent from the DA converter 5B. Consequently, a state is obtained in which measurement can be performed in the range selected by the switch circuit 3.

As such, according to the present embodiment, it is possible to provide a multi-range current detector capable of changing its range. Also, in performing selection between measurement ranges, the gain and offset values of the EEPROM 4 are used. Thus, a plurality of measurement ranges can be supported by use of the detection circuit 6C illustrated in Figure 2 without changing the connection of the current coils to modify the detection circuit 6C. As a result, measurement accuracy can be improved; and an increase in mounting area and a rise in manufacturing cost can be suppressed. Further, even after mounting the current detector, when modification of the magnitude of range or the like is required, the range modification or the like can be easily performed by varying the values of data groups of the EEPROM 4.

### [Embodiment 2]

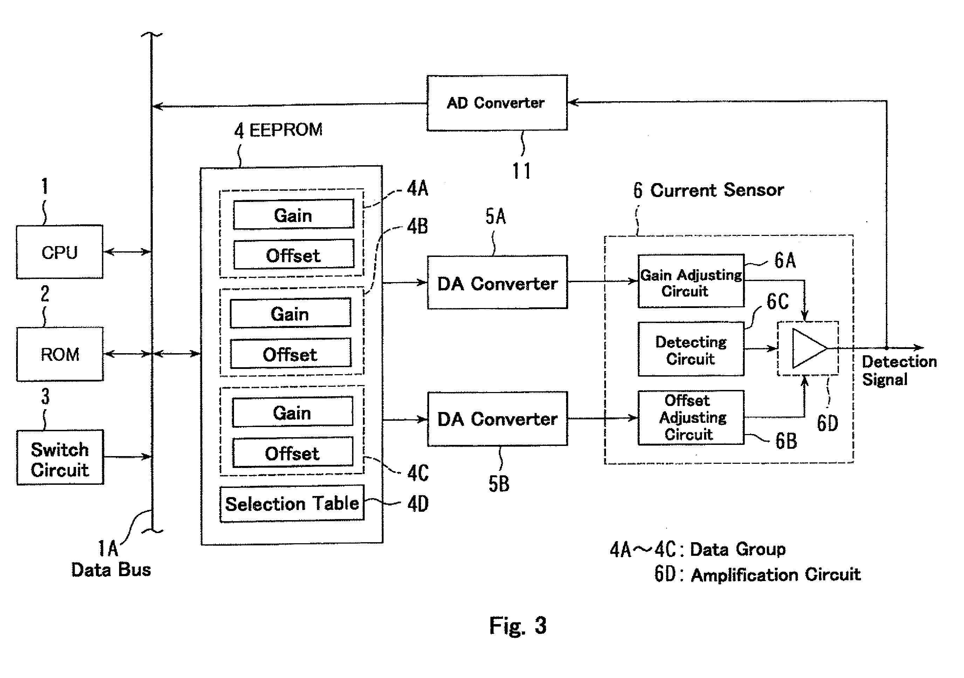

A current detector according to the present embodiment is illustrated in Figure 3. Throughout the present embodiment, it is noted that like reference characters are applied to the same or similar constituent components as the above described current detector of Figure 1, and an explanation thereof is omitted. In this current detector, in addition to the manual selection from measurement ranges by use of the switch circuit 3 of Figure 1, automatic selection of a measurement range is made possible. For this reason, the current detector of Figure 3 is provided with an AD (Analog-Digital) converter 11. The AD converter 11 converts a detection signal of the amplifier circuit 6D into a digital detection signal and sends the converted signal via the data bus 1A to the CPU 1.

In performing the automatic selection from the measurement ranges, firstly the CPU 1 sends a selection signal for reading, for example, the data group 4A being setting data for 10 [A] to the EEPROM 4. When the current sensor 6 performs current detection while being adjusted based on gain and offset values of the data group 4A, a detection signal is outputted therefrom. When receiving the detection signal from the AD converter 11, the CPU 1 detects a level of this signal and checks whether or not the detected level is within a predetermined range. Then, when the level of the detection signal is higher compared to the predetermined range, the CPU 1 sends a selection signal for reading the data group 4B being setting data for 20 [A] to the EEPROM 4.

When the detection signal sent from the AD converter 11 falls into the predetermined range, the CPU 1 holds this state to detect a current to be measured. Thereafter, for example, when the current to be measured becomes small and thus the level of the detection signal sent from the AD converter 11 lowers and becomes lower compared to the predetermined range, the CPU 1 sends a selection signal for reading the data group 4A being setting data for 10 [A] to the EEPROM 4. On the contrary, when the level of the detection signal is higher, the CPU 1 sends to the EEPROM 4 a selection signal for reading the data group 4C being setting data for 30 [A].

In this manner, the CPU 1 selects an optimum measurement range corresponding to the current to be measured.
The embodiments of the present invention have been described in detail, but specific configurations are not limited to these embodiments; an embodiment with design modifications or the like applied thereto without departing from the gist of the invention is also included in the technical scope of the invention. For example, in the above described embodiments, in order to select one from among the data groups 4A to 4C, the switch circuit 3 is used, but the present invention is not limited thereto. For example, a configuration may be employed in which when receiving a selection signal from another device, the CPU 1 sends the selection signal to the EEPROM 4.

Also, in the above described embodiments, three measurement ranges 10 [A], 20 [A] and 30 [A] are set, but the present invention is not limited thereto. For example, like conventional art, two measurement ranges 10 [A] and 20 [A] may be set, or four or more measurement ranges may be set.

Further, in the above described embodiments, an example where the present invention is applied to a current detector is described, but the present invention is applicable to various types of detectors.

### Industrial Applicability

The present invention is applicable to detectors having a plurality of measurement ranges, such as a current sensor.

## Claims

1. A detector **characterized by** comprising;
storage means having stored therein a plurality of digital value groups, each of the groups being stored as one group of digital values indicating a gain and an offset;
instruction means for supplying to the storage means an instruction for reading one set of digital values from the plurality of groups;
D/A converters (5A, 5B) for respectively converting the digital values of gain and offset read by the instruction means into analog values; and
detection means for adjusting gain and offset based on outputs from the D/A converters (5A, 5B) and then outputting a detection result.

2. The detector according to claim 1 **characterized in that** the storage means is a nonvolatile memory (4) capable of electrically rewriting the digital values.

3. The detector according to claim 2 **characterized by** further comprising rewrite means for rewriting the gain and offset values stored in the nonvolatile memory (4).
